# EUROPEAN PATENT APPLICATION

(11) **EP 1 530 243 A2**
(43) Date of publication of application: **11.05.2005**
(21) Application number: 04026127.3
(22) Date of filing: 04.11.2004
(51) Int. Cl.: H01L 35/30, F23C 11/00

(54) **An electricity generator device including a combustor matrix of porous semi-conductor material**

(30) Priority: 07.11.2003 IT TO20030882
(71) Applicant: C.R.F. Società Consortile per Azioni, 10043 Orbassano (Torino) (IT)
(72) Inventor: Perlo, Pietro, 10043 Orbassano (Torino) (IT); Zvezdin, Anatolii, 10043 Orbassano (Torino) (IT); Innocenti, Gianfranco, 10043 Orbassano (Torino) (IT); Repetto, Piermario, 10043 Orbassano (Torino) (IT); Brignone, Mauro, 10043 Orbassano (Torino) (IT); Pizzi, Marco, 10043 Orbassano (Torino) (IT); Bollito, Gianluca, 10043 Orbassano (Torino) (IT); Sgroi, Mauro, 10043 Orbassano (Torino) (IT); Finizio, Roberto, 10043 Orbassano (Torino) (IT); Carvignese, Cosimo, 10043 Orbassano (Torino) (IT)
(74) Representative: Quinterno, Giuseppe

(57) **Abstract**

The device (1) includes
a combustor (2) comprising
an inlet chamber or region (4) intended to receive a flow of fuel (5) and a fuel supporter (6) at high pressure,
an outlet chamber or region (7) or combustion product exhaust (8) at relatively lower pressure, and
at least one separation element (9) of nano-porous or micro-porous semi-conductor material which separates the inlet chamber or region (4) from the outlet chamber or region (7).

The separation element (9) has a plurality of nano-pores or micro-pores (10) passing therethrough which define communication passages between the inlet clad chamber or region (4) and the outlet chamber or region (7). The surface of these pores (10) is at least partly clad in a layer (11) of an electrically conductive or semi-conductive material which, relative to the semi-conductor material of the separation element (9) forms an essentially extended junction, in particular a p-n junction or a Schottky junction or a hetero junction.

First and second electrodes (13, 14) are connected to the cladding (11) of the pores (10) passing therethrough, and respectively, to the semi-conductor material of the separation element (9).

In operation the pores (10) act as confined microcombustion chambers and the energy developed by the combustion is able to cause creation of stable electron-hole pairs at the said junction and the generation of a corresponding potential difference (V) between the electrodes (13, 14).

## Description

The present invention relates to an electricity generator including a combustor in the form of a matrix of porous semiconductor material.

The device according to the invention is an electricity generator which is characterised in that it comprises
a combustor including
an inlet region or chamber intended to receive a flow of fuel and a combustion supporter or comburent at high pressure,
an outlet region or chamber or exhaust for the combustion products at a relatively lower pressure, and
at least one separation element of nano-porous or micro-porous semi-conductor material which separates the inlet region or chamber from the outlet region or chamber; this separation element having a plurality of nano-pores or micro-pores passing therethrough which define communication passages between the inlet region or chamber and the outlet region or chamber; the surface of the said or nano-pores or micro-pores are at least partly clad with a layer of electrically conductive or semi-conductive material which, relative to the material of the said separation element, form a substantially extensive p-n junction; and
first and second electrodes connected to the said nano-porous or micro-porous cladding and respectively to the semi-conductor material of the separation element; and
the arrangement being such that in operation the said nano-pores or micro-pores passing therethrough of the separation element function as confined combustion micro-chambers and the energy developed by the combustion is capable of causing at the said p-n junction the creation of stable electron-hole pairs and the generation of a corresponding potential difference between the said electrodes.

Further characteristics and advantages of the invention will become apparent from the following detailed description, given purely by way of non-limitative example, with reference to the attached drawings, in which:
Figure 1 is a schematic representation in axially sectioned view of a first embodiment of a device according to the invention; and
Figure 2 is a schematic representation, in partially sectioned perspective view, of a second embodiment of a device according to the invention.

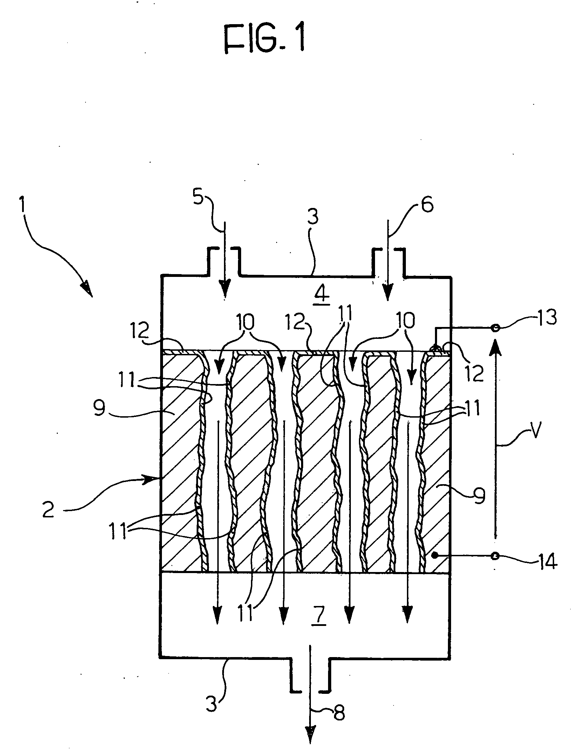

In Figure 1 an electricity generator according to the invention is generally indicated 1.

This electricity generator 1 includes a combustor generally indicated 2. In the exemplary embodiment illustrated this combustor comprises a casing 3 at a first end of which is defined an inlet region or chamber 4 intended to receive in operation a flow of fuel 5 and flow of combustion supporter 6 at high pressure.

At the opposite end of the casing 3 is defined an outlet region or chamber 7 for exhaust of the combustion products. The exhaust gases or combustion products are symbolically represented by the arrow 8.

Between the inlet region or chamber 4 and the outlet region or chamber 7 is interposed a separation element 9 essentially in the form of a sheet or disc of nano-porous or micro-porous semi-conductor material.

The separation element 9 is conveniently made of silicon and has a plurality of nano-pores or micro-pores 10 passing therethrough which define communication passages between the inlet region or chamber 4 and the outlet region or chamber 7.

The surface of the pores 10 passing through the separation element 9 is at least partly provided with a cladding formed by a layer of electrically conductive or semi-conductive material 11. The said cladding material forms a substantially extended p-n junction with respect to the semi-conductor material of the separation element 9.

The material of the cladding 11 of the nano-pores or micro-pores 10 is for example constituted by a noble metal, preferably palladium or gold, or by a doped semi-conductor material so as to present a conductivity of predetermined type or sign.

Formation of the through pores 10 can moreover be achieved by means of anodisation in a bath of hydrofluoric acid. The typical currents to obtain nano-porous silicon are of the order of 10 mA/cm². The duration of this process must be sufficient to achieve pores passing through the separation element 9.

The cladding of the wall of the nano-pores or micro-pores 10 can be formed with sol gel deposition techniques or, more generally, with CSD (Chemical Solution Deposition) techniques, or else by sputtering, or more generally with CVD (Chemical Vapour Deposition) techniques.

An apparatus for the production of porous silicon elements with pores passing therethrough clad with metal is described in earlier International patent application WO 2004/086517 in the name of the same Applicant.

Conveniently, the claddings 11 of the individual pores 10 passing therethrough are interconnected by a cladding 12 which extends over a principal surface or face of the separation element 9. In the illustrated embodiment this principal surface or face is the upper-face, facing the inlet region or chamber 4 of the combustor.

Two electrodes, indicated 13 and 14, are connected to the cladding 12 and, respectively, to the semi-conductor material which constitutes the separation element 9 in the form of sheet or disc.

The arrangement is such that in operation the pores 10 of the separation element 9 act as resonant micro-chambers in which a rapid confined combustion of the fuel 5 with the fuel supporter 6 takes place. Part of the energy developed by the combustion in each pore 10 passing therethrough is directly converted into an electron-hole pair. In effect, the reaction enthalpy of a combustion is of the order of 10 eV/molecule, whilst the energy necessary for the formation of an excitation (electron-hole pair) is typically 1 eV.

The energy developed by the combustion process principally manifests itself in the form of kinetic energy of the molecules of the reaction products (it can also partly develop as visible or infrared photons for example flame). Given that the combustion takes place in a confined space of the dimensions of several tens of nm or less, the kinetic modes of the gas molecules are strongly inhibited. The energy associated with these modes must nevertheless be dissipated in some way and this takes place in part in the form of phonons (on the surface of the pores 10 which host the reaction) and partly in the form of electronic excitation of the atoms of the walls of the said pores (by kinetic energy of the gas upon excitation of the electrons). The phonons cause an increase in the temperature of the walls of the cavity. The electric charges present in the semi conductor-semi conductor or Schottky junction formed at the wall of the pores 10 passing therethrough by virtue of the energetic configuration of the junction itself, when excited form an electron-hole pair (the exciton). Because of the internal electric field the electrons and the holes tend to separate spatially migrating towards opposite electrodes and thus generating a potential difference between the electrodes 13 and 14 which, when applied to a utiliser apparatus, allows an electric current to flow.

Naturally, different electricity generator devices as described above can be connected together in interconnection modes known per se, to make available a potential difference of higher voltage and/or a greater or lesser current.

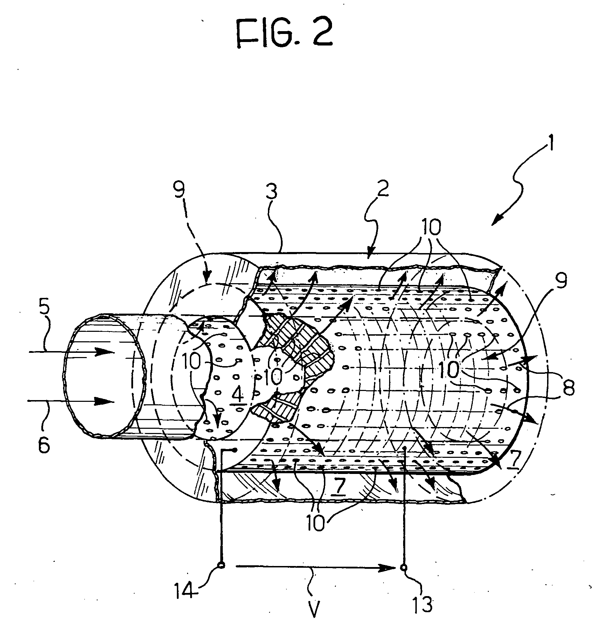

In Figure 2 of the attached drawings there is schematically shown a variant embodiment of a device according to the invention. In this Figure the parts and elements which are the same as or essentially equivalent to components already described have again been given the same reference numerals as previously utilised.

In the device according to Figure 2, the separation element 9 of semiconductor material has an essentially tubular form and the said nano-pores or micro-pores 10 extend essentially radially between the inner surface and the outer surface thereof.

In the illustrated embodiment the inlet region or chamber 4 for the fuel 5 and the combustion supporter 6 correspond to the internal region of the tubular separation element 9, whilst the outlet region or chamber 7 for the exhaust of the combustion products 8 surrounds the separation element 9.

In the embodiment according to Figure 2 the surface of the pores 10 passing therethrough is also provided with a layer of electrically conductive or semi-conductive cladding material capable of forming, together with the semi-conductor material which constitutes the separation element 9, an extended p-n junction.

The claddings of the pores 10 of the separation element 9 are interconnected by a cladding 12 which extends for example onto the outer surface of the separation element 9.

The modes of operation of the device according to Figure 2 are similar to those previously described in relation to the device shown in Figure 1.

Naturally, the principle of the invention remaining the same, the embodiments and details of construction can be widely varied with respect to what has been described and illustrated purely by way of non-limitative example, without by this departing from the ambit of the invention as defined in the annexed claims.

## Claims

1. An electricity generator device (1) including
a combustor (2) comprising
an inlet region or chamber (4) intended to receive a flow of fuel (5) and a combustion supporter (6) at high pressure,
an outlet region or chamber (7) or combustion product exhaust (8) at relatively lower pressure, and
at least one separation element (9) of nano-porous or micro-porous semi-conductor material which separates the inlet region or chamber (4) from the outlet region or chamber (7); the separation element (9) having a plurality of nano-pores or micro-pores (10) passing therethrough which define communication passages between the inlet region or chamber (4) and the outlet region or chamber (7); the surface of the said pores (10) passing therethrough being at least partly clad in a layer (11) of electrically conductive or semi-conductive material which, relative to the semi-conductor material of the separation element (9), substantially forms an extended junction, in particular a p-n junction or a Schottky junction or a hetero junction; and
first and second electrodes (13, 14) connected to the cladding (11) of the said pores (10) passing therethrough and, respectively, to the semi-conductor material of the separation element (9);
the arrangement being such that in operation the said pores (10) passing therethrough act as confined combustion microchambers and the energy developed by the combustion is capable of causing, in the said junction, the creation of stable electron-hole pairs and the generation of a corresponding potential difference (V) between the said electrodes (13, 14).

2. An electricity generator device according to Claim 1, in which the semi-conductor material of the separation element (9) is silicon, and the cladding (11) of its pores (10) passing therethrough is made of a catalyzing material or a noble metal, in particular palladium or gold or platinum, or with a doped semi-conductor material having a conductivity of predetermined type or sign.

3. An electricity generator device according to Claim 1 or Claim 2, in which the separation element (9) is made in the form of disc or sheet.

4. An electricity generator device according to Claim 1 or Claim 2, in which the separation element (9) is essentially of tubular form and the said pores (10, 11) passing therethrough extend between its internal surface and its external surface.

5. An electricity generator device according to any preceding claim, in which the claddings (11) of the pores (10) passing through the separation element (9) are interconnected by a cladding (12) which extends over a principal face or surface of the separation element (9) facing the inlet chamber or region (4) or the outlet chamber or region (7).
